# EUROPEAN PATENT APPLICATION

(11) **EP 2 136 394 A1**
(43) Date of publication of application: **23.12.2009**
(21) Application number: 08739177.7
(22) Date of filing: 28.03.2008
(51) Int. Cl.: H01L 21/60, H01L 23/12

(54) **SEMICONDUCTOR DEVICE**

(30) Priority: 29.03.2007 JP 2007088657; 10.01.2008 JP 2008003181
(71) Applicant: NEC Corporation, Minato-ku Tokyo 108-8001 (JP)
(72) Inventor: FUJIMURA, Yuuki, Tokyo 108-8001 (JP); WATANABE, Sinji, Tokyo 108-8001 (JP)
(74) Representative: Glawe, Delfs, Moll
(86) International application number: PCT/JP2008/056053
(87) International publication number: WO 2008/120705

(57) **Abstract**

Semiconductor device has semiconductor chip having first electrode on one face, circuit board having second electrode on mounting face, warp suppressing layer to suppress warp of at least semiconductor chip, and stress relaxing layer to relax stress arising between semiconductor chip and warp suppressing layer. Semiconductor chip is mounted on circuit board so as to electrically connect first electrode with second electrode of circuit board and to oppose one face to mounting face. Stress relaxing layer is provided on back face of one face in semiconductor chip. Warp suppressing layer is laminated on semiconductor chip via stress relaxing layer. Stress relaxing layer has spacer to maintain predetermined gap between semiconductor chip and warp suppressing layer. Stress relaxing layer has Young's modulus lower than that of warp suppressing layer. Stress relaxing layer and warp suppressing layer have coefficients of linear expansion greater than that of semiconductor chip.

## Description

### FIELD OF THE INVENTION

### [REFERENCE TO RELATED APPLICATION]

The present invention is based on the benefit of the priority of the Japanese Patent Applications No. 2007-088657 filed on March 29, 2007 and No. 2008-003181 filed on January 10, 2008, and the disclosures in these applications are incorporated herein in its entirety by reference thereto.
The present invention relates to a semiconductor device and, in particular, a semiconductor device in which a semiconductor chip is mounted on a circuit board.

### BACKGROUND ART

An electronic apparatus and electrical apparatus are becoming thinner, and therefore a semiconductor device incorporated into these apparatuses is required to become thinner. As a method of mounting a semiconductor chip on a circuit board, a flip-chip mounting package and wafer level chip size package (WLCSP) are carried out.

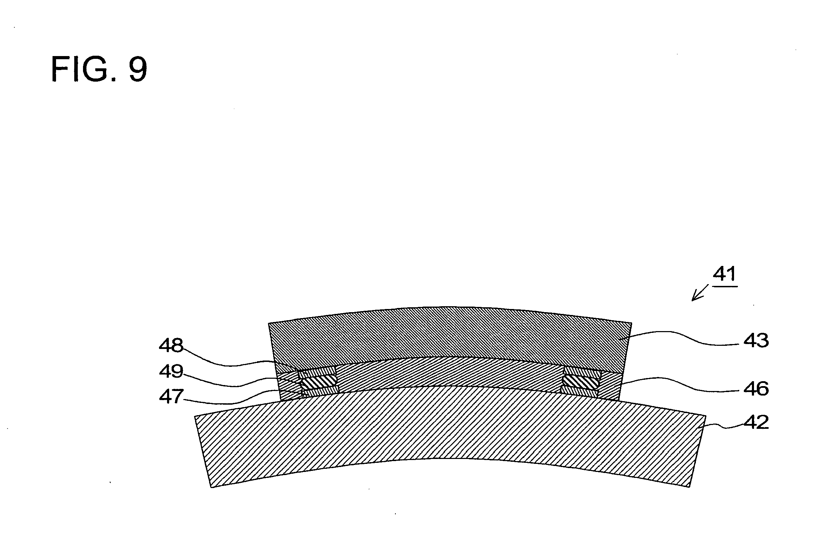

Fig. 9 illustrates a schematically cross-sectional view of a semiconductor device according to the background art in which a semiconductor chip is mounted by the flip-chip method. In a semiconductor device 41, a semiconductor chip 43 is mounted on a circuit board 42 so as to electrically connect each electrode 48 of the semiconductor chip 43 with an electrode 47 of the circuit board 42 via a bump 49. Under-fill resin 46 is filled between the semiconductor chip 43 and the circuit board 42.

In a process of manufacturing the semiconductor device 41, the semiconductor device 41 is heated in a reflow soldering step of electrically connecting the electrode 48 of the semiconductor chip 43 with the electrode 47 of the circuit board 42 via the bump 49 and a step of filling and hardening the under-fill resin 46 between the semiconductor chip 43 and the circuit board 42.

The semiconductor chip 43 generally has a coefficient of linear expansion of 2.6 ppm/C°, whereas the circuit board 42 has a coefficient of linear expansion of 10 ppm/C° to 40 ppm/C° which is higher than that of the semiconductor chip 43. When the semiconductor device 41 is heated and cooled in the manufacturing process, a warp arises in the semiconductor device 41 because of the difference between expansion and contraction of the semiconductor chip 43 and that of the circuit board 42. When the semiconductor device 41 is cooled after the application of heat, for example, the force to curve the semiconductor device 41 as shown in Fig. 9 is generated because the circuit board 42 contracts more greatly than the semiconductor chip 43.

This warp of the semiconductor device 41 causes the connection defect upon the bump 49 which electrically connects the circuit board 42 with the semiconductor chip 43. When the semiconductor device 41 is mounted on a main board, a change in shape by the temperature change makes it higher the possibility that the connection with the main board is broken by fatigue.

In the WLCSP in which the substrate facing to a face having the electrode of the semiconductor chip is a redistribution layer, when the distribution layer is formed of polyimide, applying heat to high temperature is necessary to harden polyimide, and this also causes the contraction by the hardening. Therefore, the force to curve the semiconductor device arises in the same way as the flip-chip mounting package because of the connection of the redistribution layer with the semiconductor chip whose expansion and contraction are different from those of the redistribution layer.

The warp of the semiconductor device arising from the difference between the coefficient of linear expansion of the semiconductor chip and that of the circuit board may be restrained by the rigidity of the semiconductor device itself. In the semiconductor device which is becoming thinner, however, the warp arises more easily because the rigidity is falling. In Patent Documents 1 and 2, for example, the art to cure the warp of the semiconductor device is disclosed.

A semiconductor device described in Patent Document 1 comprises a board, a semiconductor chip mounted on the board, a resin material to bond the semiconductor chip to the board, and a curing material stuck to the back of a face with the resin material in the semiconductor chip. The curing material may cure a warp of the semiconductor chip caused by expansion or contraction of the resin material having a coefficient of linear expansion which is different from that of the semiconductor chip.

A semiconductor device described in Patent Document 2 comprises bonding means of bonding a semiconductor chip to a mounting board and adjusting means of adjusting a bend of the semiconductor chip. The bonding means bends the semiconductor chip corresponding to expansion and contraction of the mounting board to disperse stress generated by the expansion and contraction of the mounting board to the semiconductor chip as well as a conductive electrode. The adjusting means cures or relieves the bend of the semiconductor chip because the change in shape of the semiconductor chip causes a crack.

[Patent Document 1] JP Patent Kokai Publication No. JP-P2004-96015A
[Patent Document 2] JP Patent Kokai Publication No. JP-A-06-232210

### DISCLOSURE OF THE INVENTION

### PROBLEMS TO BE SOLVED BY THE INVENTION

The disclosures of Patent Documents 1 and 2 are incorporated herein in its entirety by reference thereto. An analysis of the background art is given by the present invention below.
The warp of the semiconductor device caused by the difference in the coefficient of expansion and contraction in a time of heating and cooling may be suppressed by increasing the thickness of the semiconductor chip or the circuit board to enhance the rigidity of the semiconductor device itself. However, this departs from slimming required for the semiconductor device as used in the mobile device.

In Patent Documents 1 and 2, the curing material (adjusting means) is bonded to the semiconductor chip by an adhesive layer. However, there is a possibility that the thickness of the adhesive layer is uneven if the curing material is merely pushed and stuck to the semiconductor chip through the adhesive layer and that, in an extreme case, any separated portion arises between the curing material and the semiconductor chip. The concentration of the stress on the thinner part of the adhesive layer causes cracks.

In order to bond the curing material to the adhesive layer (sic. semiconductor chip) by the adhesive layer, it is necessary that the adhesive layer changes in shape in the time of bonding and maintains the close adhesion between the curing material and the semiconductor chip. That is, at the time of bonding, the adhesive layer is preferably in a gel or liquid state. However, if the adhesive layer is soft, the thickness of the adhesive layer can not be controlled because of the load upon bonding. If a thermosetting resin is used as the adhesive layer, for example, the thermosetting resin is required to apply heat and pressure in the time of bonding to the semiconductor chip. However, the thickness of the adhesive layer can not be maintained enough because the adhesive layer flows out by applying pressure owing to very low viscosity of the thermosetting resin at a start of applying heat. If the adhesive layer is thin, it can not absorb the stress arising from the difference between the expansion and contraction of the curing material and those of the semiconductor chip and is broken, and thus resulting in detachment of the curing material from the semiconductor chip. On the other hand, if the pressure is not applied, the adhesive layer is hardened in an uneven (no parallel) state between the semiconductor chip and the curing material.

If the adhesive layer is hard, in a similar manner to the case of the thin adhesive layer, the adhesive layer can not absorb the stress arising from the difference between the expansion and contraction of the curing material and those of the semiconductor chip and is broken, and thus resulting in this detachment of the curing material from the semiconductor chip.

It is an object of the present invention to provide a thin semiconductor device in which a warp can be restrained in a various temperature environment ranging from a using environment at low temperature to a mounting environment at high temperature.

### PROBLEMS TO BE SOLVED BY THE INVENTION

According to a first aspect of the present invention, a semiconductor device is provided, the device comprising: a semiconductor chip having a first electrode on one face; a circuit board having a second electrode on a mounting face; a warp suppressing layer to suppress a warp of at least the semiconductor chip; and a stress relaxing layer to relax stress arising between the semiconductor chip and the warp suppressing layer. The semiconductor chip is mounted on the circuit board so as to electrically connect the first electrode with the second electrode of the circuit board and to oppose the one face to the mounting face. The stress relaxing layer is provided on a back face of the one face in the semiconductor chip. The warp suppressing layer is laminated on the semiconductor chip via the stress relaxing layer. The stress relaxing layer has a spacer to maintain a predetermined gap between the semiconductor chip and the warp suppressing layer. The stress relaxing layer has a Young's modulus lower than that of the warp suppressing layer. The stress relaxing layer and the warp suppressing layer have coefficients of linear expansion greater than that of the semiconductor chip.

According to a second aspect of the present invention, a semiconductor device is provided, the device comprising: a semiconductor chip having a first electrode on one face; a circuit board having one face which faces to the semiconductor chip, a back face of the one face, a second electrode on the back face, and a conductor electrically connected with the second electrode and transversely extending from the back face to the one face; a warp suppressing layer to suppress a warp of at least the semiconductor chip; and a stress relaxing layer to relax stress arising between the semiconductor chip and the warp suppressing layer. The semiconductor chip is mounted on the circuit board so as to electrically connect the first electrode with the second electrode of the circuit board through the conductor and to contact the one face of the semiconductor chip with the one face of the circuit board. The stress relaxing layer is provided on the back face of the one face in the semiconductor chip. The warp suppressing layer is laminated on the semiconductor chip via the stress relaxing layer. The stress relaxing layer has a spacer to maintain a predetermined gap between the semiconductor chip and the warp suppressing layer. The stress relaxing layer has a Young's modulus lower than that of the warp suppressing layer. The stress relaxing layer and the warp suppressing layer have coefficients of linear expansion greater than that of the semiconductor chip.

In the present invention, the Young's modulus of the warp suppressing layer and the semiconductor chip are measured in conformity with JISZ2241. The Young's modulus of the stress relaxing layer and the circuit board are measured in conformity with JISK7127. The coefficients of linear expansion of the warp suppressing layer and the semiconductor chip are measured in conformity with JISZ2285. The coefficients of linear expansion of the stress relaxing layer and the circuit board are measured in conformity with JISK7197. The Young's modulus and the coefficient of linear expansion are measured within a temperature range not exceeding the glass transition temperatures of the stress relaxing layer and the circuit board.

### MERITORIOUS EFFECTS OF THE INVENTION

The semiconductor device of the present invention has the warp suppressing layer and stress relaxing layer on the semiconductor chip. This can restrain the warp of the semiconductor device by the temperature change. By suppressing the warp, it is possible to enhance reliability of the connection of the semiconductor chip with the circuit board and to improve a yield of a secondary mounting of the semiconductor device.

In the semiconductor device, the stress relaxing layer having a spacer is provided between the warp suppressing layer and the semiconductor chip. This can prevents the difference between the expansion and contraction of the warp suppressing layer and those of the semiconductor chip from detaching the warp suppressing layer from the semiconductor chip. The warp suppressing layer can be also made thinner because the stress relaxing layer can increase the Young's modulus. This can make the whole semiconductor device thinner.

### BRIEF DESCRIPTION OF THE DRAWINGS

Fig. 1 illustrates a schematically cross-sectional view of a semiconductor device according to a first exemplary embodiment of the present invention.
Fig. 2 illustrates a schematically enlarged view of a stress relaxing layer and a warp suppressing layer illustrated in Fig. 1.
Fig. 3 illustrates a schematically cross-sectional view of a semiconductor device according to a second exemplary embodiment of the present invention.
Fig. 4 illustrates a schematically enlarged view of a stress relaxing layer in a semiconductor device according to a third exemplary embodiment of the prevent invention.
Fig. 5 illustrates a schematically enlarged view of a stress relaxing layer in a semiconductor device according to a third exemplary embodiment of the prevent invention.
Fig. 6 illustrates a schematically perspective view of a semiconductor device of the present invention.
Fig. 7 illustrates a schematically and partially cross-sectional view of a state that a semiconductor device of the present invention is secondarily mounted on a main board.
Fig. 8 illustrates a schematically cross-sectional view of a semiconductor device according to a fifth exemplary embodiment of the present invention.
Fig. 9 illustrates a schematically cross-sectional view of a semiconductor device according to the background art.

### EXPLANATION OF REFERENCE SYMBOLS

- 1: Semiconductor device
- 2: Circuit board
- 3: Semiconductor chip
- 4: Stress relaxing layer
- 4a: Resin
- 4b, 4c, 4d: Spacer
- 5: Warp suppressing layer
- 6: Under-fill Resin
- 7: Electrode
- 8: Electrode
- 9: Bump
- 11: Semiconductor device
- 12: Circuit board
- 13: Insulating layer
- 14: Rewiring circuit
- 15: Outside connection electrode
- 16: Outside connection electrode
- 21: Main board
- 22: External connection electrode
- 23: Bump
- 24: Electronic element
- 25: Bump
- 31: Semiconductor device
- 32: Circuit board
- 33: Ground electrode
- 34: Conductive resin
- 41: Semiconductor device
- 42: Circuit board
- 43: Semiconductor chip
- 46: Under-fill Resin
- 47: Electrode
- 48: Electrode
- 49: Bump

### PREFERRED MODES FOR CARRYING OUT THE INVENTION

According to a preferred mode of first and second aspects of the present invention, the warp suppressing layer has a coefficient of linear expansion not less than that of the circuit board.

According to a preferred mode of the first and second aspects of the present invention, the stress relaxing layer has a thickness of 20 µm to 60 µm.

According to a preferred mode of the first and second aspects of the present invention, the stress relaxing layer has a Young's modulus of 10 GPa to 40 GPa.

According to a preferred mode of the first and second aspects of the present invention, at least one material of the spacer is glass, ceramics, metal or resin.

According to a preferred mode of the first and second aspects of the present invention, the spacer has a sheet shape, granular shape or pillar shape.

According to a preferred mode of the first and second aspects of the present invention, the stress relaxing layer has a spacer and a resin to bond the semiconductor chip with the warp suppressing layer.

According to a preferred mode of the first and second aspects of the present invention, a lamination of the stress relaxing layer and the warp suppressing layer has a Young's modulus not less than that of the circuit board.

According to a preferred mode of the first and second aspects of the present invention, the circuit board comprises a resin. The stress relaxing layer comprises a resin. The difference between the glass transition temperature of the resin of the circuit board and that of the resin of the stress relaxing layer is within a range plus/minus of 20 °C.

According to a preferred mode of the first and second aspects of the present invention, the warp suppressing layer is formed of a conductor. The circuit board has a ground electrode. The warp suppressing layer is electrically connected with the ground electrode. According to a further preferred mode, the semiconductor device further comprises a conductive resin. At least one part of the warp suppressing layer protrudes from the semiconductor chip. The conductive resin is provided between the protruding part of the warp suppressing layer and the ground electrode.

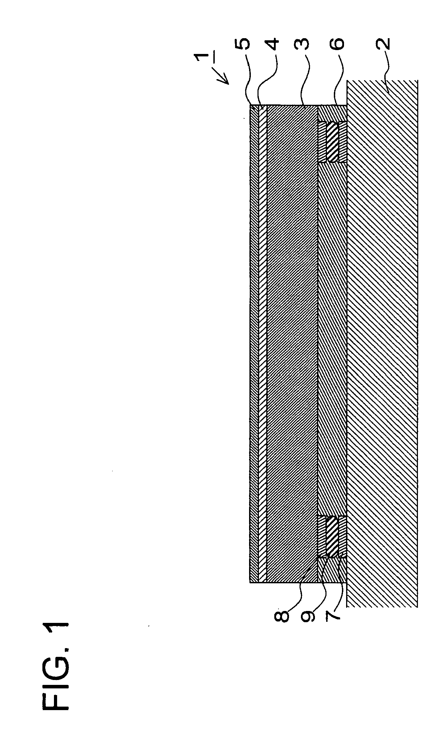

A semiconductor device according to a first exemplary embodiment of the present invention will be explained below. Fig. 1 illustrates a schematically cross-sectional view of the semiconductor device according to the first exemplary embodiment of the present invention. The semiconductor device 1 has a circuit board 2 having board electrodes 7, and a semiconductor chip 3 mounted on the circuit board 2 by the flip-chip method. A face having electrodes 8 of the semiconductor chip 3 is opposite to a face having the board electrodes 7 of the circuit board 2. Each electrode 8 is electrically connected with the board electrode 7 through a bump 9 made of a metal such as gold or solder, or conductive resin. Under-fill resin 6 is filled between the semiconductor chip 3 and the circuit board 2 so as to fill a gap between the both.

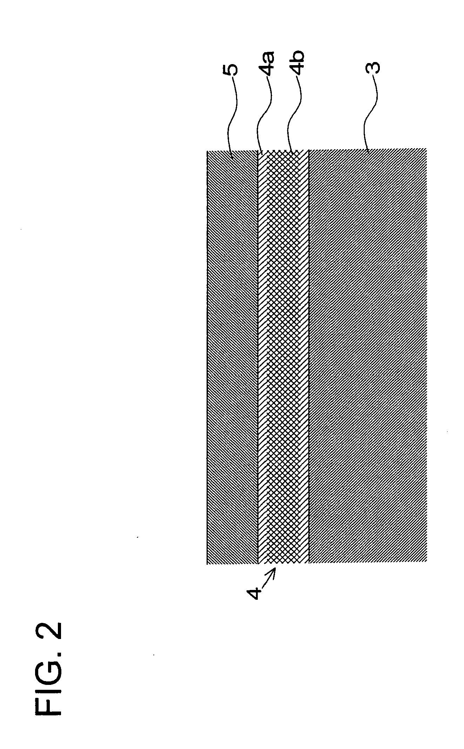

A stress relaxing layer 4 is formed on the back face of a face of the semiconductor chip 3 facing to the circuit board 2, and a warp suppressing layer 5 is formed on the stress relaxing layer 4. Fig. 2 illustrates a schematically enlarged view of the stress relaxing layer 4 and the warp suppressing layer 5 illustrated in Fig. 1.

The stress relaxing layer 4 is a layer to relax or absorb stress arising from the difference between expansion and contract of the semiconductor chip 3 and those of the warp suppressing layer 5. The stress relaxing layer 4 has a spacer 4b to maintain a predetermined thickness, that is, a predetermined gap between the semiconductor chip 3 and the warp suppressing layer 5. In the exemplary embodiment illustrated in Fig. 2, the illustrated spacer 4b is a sheet type covered with resin 4a (or impregnated with resin 4a). The stress relaxing layer 4 has a function of bonding the semiconductor chip 3 to the warp suppressing layer 5 in addition to a function of relaxing the stress between the semiconductor chip 3 and the warp suppressing layer 5. In order to be closely bonded with the both, it is therefore preferred that the resin 4a of the stress relaxing layer 4 is sufficiently deformable, i.e., changeable in shape (a gel type or liquid type, for example) in the step of bonding the warp suppressing layer 5 to the semiconductor chip 3. If the stress relaxing layer 4 has no spacer, it is difficult to maintain the thickness of the stress relaxing layer 4 because, when the pressure is applied to closely bonding the stress relaxing layer 4 to the semiconductor chip 3 and the warp suppressing layer 5, the resin 4a flows out due to the change in shape. Unless the stress relaxing layer 4 has an enough thickness, as explained below, the stress relaxing layer 4 can not relax the stress arising from the difference between the expansion and contraction of the semiconductor chip 3 and those of the warp suppressing layer 5 and therefore would be broken itself.

The spacer 4b also has a function of increasing the Young's modulus of the stress relaxing layer 4. In the semiconductor device 1 of the present invention, although the warp is mainly suppressed by the warp suppressing layer 5, it is possible to reduce the thicknesses of the warp suppressing layer 5 and the stress relaxing layer 4 required for suppressing the warp of the semiconductor device 1, if the Young's modulus of the stress relaxing layer 4 can be also increased. By providing the spacer 4b in the stress relaxing layer 4, the Young's modulus becomes higher than that of a stress relaxing layer made of resin only, for example, to help to thin down the semiconductor device 1.

A coefficient of linear expansion of the stress relaxing layer 4 is higher than a coefficient of linear expansion of the semiconductor chip 3 in order to suppress the warp arising from the difference between expansion and contraction of the circuit board 2 and those of the semiconductor chip 3.

It is preferred that the glass transition temperatures of the resin 4a of the stress relaxing layer 4 and resin of the circuit board 2 are higher than a temperature range in use of the semiconductor device 1. If the glass transition temperatures of the resin 4a of the stress relaxing layer 4 and the resin of the circuit board 2 do not exceed the temperature range for the use of the semiconductor device 1, it is preferred that both glass transition temperatures coincide each other as far as possible by, for example, using the same material. If both the glass transition temperatures are different, it is preferred that the glass transition temperature of the resin 4a of the stress relaxing layer 4 is within plus/minus 20% of the glass transition temperature of the resin of the circuit board 2. The Young's modulus of the circuit board 2 greatly changes at about (above and below) the glass transition temperature of the resin. At about this glass transition temperature, a force to curve the semiconductor device 1, which is generated between the circuit board 2 and the semiconductor chip 3, also changes. If an environmental temperature of the semiconductor device rises from under to the glass transition temperature or above of the circuit board, for example, the Young's modulus of the circuit board decreases and the force to curve the semiconductor device becomes weaker. Unless the Young's modulus of the stress relaxing layer 4 decreases synchronously with the lowering of the Young's modulus of the circuit board 2, the stress relaxing layer 4 and the warp suppressing layer 5 would conversely curve the semiconductor device 1. It is therefore preferred that the force on the circuit board 2 side of the semiconductor chip 3 is balanced with the force on the warp suppressing layer 5 side, and that the changes in the strength of the force by the temperature change in agreement. Thus, if the glass transition temperature of the resin 4a of the stress relaxing layer 4 is within a predetermined range of the glass transition temperature of the resin of the circuit board 2, it is possible to cope with the change in the Young's modulus of the circuit board 2 by the temperature change. Meanwhile, the Young's modulus of the stress relaxing layer 4 at about the glass transition temperature may be higher or lower than that of the circuit board 2.

The Young's modulus (tensile elastic modulus) of the stress relaxing layer 4 is set at a lower value than that of the warp suppressing layer 5. If the stress relaxing layer 4 is harder than the warp suppressing layer 5, the stress relaxing layer 4 itself would be fractured when the stress arising from the difference between expansion and contraction of the warp suppressing layer 5 and those of the semiconductor chip 3 is applied. The Young's modulus of the stress relaxing layer 4 is preferably 10 GPa to 40 GPa. The Young's modulus of the semiconductor chip 3 is about 200 GPa, and the Young's modulus of the warp suppressing layer 5 formed of, for example, metal, is also about 200 GPa. It is necessary that the stress relaxing layer 4 is softer than the semiconductor chip 3 or the warp suppressing layer 5 for achieving a sufficiently close adhesion to the semiconductor chip 3 and the warp suppressing layer 5. This can be confirmed by the fact of good bonding of a common place board having a Young's modulus of about 30 GPa with metal. As explained above, for the requirement of the thinned semiconductor device 1, it is necessary that the stress relaxing layer 4 has a sufficient Young's modulus to fulfill the function of relaxing the stress without being broken. In order to thin the semiconductor device 1, it is preferred that the stress relaxing layer 4 also has the warp relaxing effect. In fact, when the stress relaxing layer 4 had a Young's modulus of 10 GPa to 40 GPa, the effect of suppressing the warp could be confirmed. However, when the stress relaxing layer 4 had the Young's modulus of about 5 GPa, the warp suppressing effect of the stress relaxing layer 4 could not be obtained because of deformation in the direction of thickness.

The stress relaxing layer 4 preferably has a thickness of 20 µm or more. When the stress relaxing layer 4 had a thickness of 10 µm, in a reliability test, the concentration of the stress arising from the difference between the coefficient of linear expansion of the warp suppressing layer 5 and that of the semiconductor chip 3 sometimes detached and broke the stress relaxing layer 4 even if the stress relaxing layer 4 was soft, namely, at a Young's modulus of about 10 GPa. Thus, the stress relaxing layer 4 preferably has a thickness of 20 µm or more. The stress relaxing layer 4 preferably has a thickness of 60 µm or less because the stress relaxing layer 4 is too thick to be mounted on a device of a thin type. In addition, when the stress relaxing layer 4 had a thickness of 65 µm, the deformation in the direction of thickness easily occurred due to easy movement of the resin, and therefore deterioration of the warp suppressing effect was observed.

Accordingly, the stress relaxing layer 4 in the present invention has the function of bonding the warp suppressing layer 5 to the semiconductor chip 3, the function of relaxing the stress, arising from the difference in expansion and contraction, between the semiconductor chip 3 and the warp suppressing layer 5, and the function of suppressing the warp of the semiconductor device 1 (the semiconductor chip 3 and the circuit board 2, especially). As the stress relaxing layer 4, a resin sheet which is a glass cloth 4b (either woven material or nonwoven material) as a spacer impregnated with the resin 4a may be used, for example. As the spacer, metal, ceramics, or resin may be also used, for example. As the resin 4a, epoxy resin or polyimide resin may be used, for example.

The warp suppressing layer 5 is a layer of suppressing the warp of at least the semiconductor chip 3 caused by expansion (or elongation) or contraction of the circuit board 2. The coefficient of linear expansion of the warp suppressing layer 5 is therefore set higher than that of the semiconductor chip 3. As the warp suppressing layer 5, metal which has high elasticity, has a high coefficient of linear expansion, and is hard to be plastically deformed under a condition that heat and pressure are applied upon lamination onto the semiconductor chip 3 may be preferably used. As a preferable metal material, stainless steel, nickel or iron may be used, for example. The warp suppressing layer 5 preferably has a coefficient of linear expansion of 15 ppm/°C to 50 ppm/°C. The warp suppressing layer 5 preferably has a Young's modulus of 60 GPa to 200 GPa. Because the generally used circuit board 2 has a coefficient of linear expansion of about 15 ppm/°C and a Young's modulus of 40 GPa, the higher coefficient of linear expansion and the higher Young's modulus of the warp suppressing layer 5 than those of the circuit board 2 can make the warp suppressing layer 5 thinner than the circuit board 2, contributing to thinning of the whole semiconductor device 1.

In order to suppress the warp of the semiconductor device 1, the Young's modulus of the lamination of the stress relaxing layer 4 and the warp suppressing layer 5 is preferably not less than that of the circuit board 2.

It is preferred that the surface sizes (areas) of the stress relaxing layer 4 and the warp suppressing layer 5 are at least equal to the surface size (area) of the semiconductor chip 3 onto which the stress relaxing layer 4 and the warp suppressing layer 5 (i. e., the stress relaxing layer 4 and the warp suppressing layer 5 are formed on the entire surface of the semiconductor chip 3). If the surface sizes of the stress relaxing layer 4 and the warp suppressing layer 5 are larger, the greater force to suppress the warp of the semiconductor device 1 can be obtained, and the semiconductor device 1 are made thinner. In the process of manufacturing the semiconductor device 1, because of a wafer level process, the productivity can be also enhanced, and the secondary mounting area can be reduced. However, if the warp of the semiconductor device 1 arising from the difference between the expansion and contraction of the semiconductor chip 3 and those of the circuit board 2 can be suppressed, the stress relaxing layer 4 and the warp suppressing layer 5 are not required to be formed on the entire surface of the semiconductor chip 3, to have a surface size sufficient to suppress the warp of the semiconductor device 1.

In the semiconductor device according to the first exemplary embodiment shown in Figs. 1 and 2, an example of the size of each element will be explained below. For the circuit board 2 having a thickness of 0.4 mm (a coefficient of linear expansion of 15 ppm/°C or less, a Young's modulus of 40 GPa or less), a semiconductor chip 3 having a thickness of 0.1 mm (a coefficient of linear expansion of 2.6 ppm/°C) and an under-fill resin 6 having a thickness of 0.05 mm, the stress relaxing layer 4, which is the glass cloth impregnated with the resin, may have a thickness of 0.6 mm (a coefficient of linear expansion of 15 ppm/°C to 30 ppm/°C, a Young's modulus of 15 GPa), and a warp suppressing layer 5 may have a thickness of 0.04 mm (a coefficient of linear expansion of 15 ppm/°C to 50 ppm/°C, a Young's modulus of 193 GPa).

Next, a mechanism for suppressing the warp of the semiconductor chip 3 in the semiconductor device 1 of the present invention will be explained below. If there is no stress relaxing layer 4 and warp suppressing layer 5, by the heating of the reflow soldering step and the cooling after the step, for example, the difference in expansion and contraction arises from the difference between the coefficient of linear expansion of the circuit board 2 and that of the semiconductor chip 3 as explained in Background Art, and, as shown in Fig. 9, the circuit board 42 and the semiconductor chip 43 generate a force to warp the semiconductor device 41. In the present invention, however, the warp suppressing layer 5 and the stress relaxing layer 4 having a higher coefficient of linear expansion than that of the semiconductor chip 3 are formed on the surface of the semiconductor chip 3 on the back side of the circuit board 2. The force of warping the semiconductor device 1 by the warp suppressing layer 5, the stress relaxing layer 4 and the semiconductor chip 3 is generated in the opposite direction of a force by the circuit board 2 and the semiconductor chip 3. The force on the warp suppressing layer 5 side is offset against the force on the circuit board 2 side to suppress the warp of the whole semiconductor device 1. Although the under-fill resin 6 generates the force of warping the semiconductor device 1 in a similar way to the circuit board 2, the influence on the warp is little because the under-fill resin 6 is thinner and has a less rigidity than the circuit board 2. Therefore, in the present invention, the influence of the under-fill resin 6 is not considered.

The semiconductor device 1 of the present invention makes use of the difference between the coefficient of linear expansion of the warp suppressing layer 5 and that of the semiconductor chip 3. However, the greater the difference between both linear expansion coefficients becomes, the greater stress is applied between the warp suppressing layer 5 and the semiconductor chip 3. The warp suppressing layer 5 could be detached from the semiconductor chip 3. In the present invention, the stress relaxing layer 4 having a predetermined thickness and the Young's modulus higher than that of the warp suppressing layer 5 is provided between the warp suppressing layer 5 and the semiconductor chip 3. The stress arising from the difference between expansion and contraction of the semiconductor chip 3 and those of the warp suppressing layer 5 is relaxed by deforming the stress relaxing layer 4 in the in-plane direction (the extending direction of the stress relaxing layer 4 (right and left directions in Fig. 1, for example)). Even if there arises the difference in expansion and contraction between over and under the stress relaxing layer 4 (on the semiconductor chip 3 side and on the warp suppressing layer 5 side), the stress relaxing layer 4 can absorb the stress without being broken because the spacer 4b can maintain the thickness of the stress relaxing layer 4. The spacer 4b also increases the Young's modulus of the stress relaxing layer 4 itself.

Therefore, in the semiconductor device 1 of the present invention, even if the expansion and contraction arise due to the temperature change, the warp of the semiconductor device 1 can be suppressed without any defect.

Next, a process of manufacturing the semiconductor device according to the first exemplary embodiment will be explained below. A liquid under-fill resin 6 is applied on a circuit board 2. By applying heat and pressure to a semiconductor chip 3 for the connection, the flip-chip mounting package is formed. Next, a stress relaxing layer 4 (a resin sheet which is glass cloth impregnated with thermosetting resin, for example) is temporarily bonded on the semiconductor chip 3. Next, a warp suppressing layer 5 (metal foil, for example) is bonded to the stress relaxing layer 4 by applying heat and pressure to manufacture a semiconductor device 1.

The power of suppressing the warp by the warp suppressing layer 5 can be controlled by adjusting the temperatures of the warp suppressing layer 5 and the circuit board 2 in the step of mounting the warp suppressing layer 5. The temperature of the warp suppressing layer 5 depends on the temperature of a tool for applying pressure to the warp suppressing layer 5 in the mounting step, and the temperature of the circuit board 2 depends on the temperature of a stage. The higher the temperature of the warp suppressing layer 5 than that of the circuit board 2 in the mounting step and the greater the difference between both temperatures becomes, the stronger the warp suppression action of the warp suppressing layer 5 becomes. The greater the difference between both temperatures becomes (the higher the temperature of the warp suppressing layer 5 becomes), the greater the power acts in a direction so as to make the surface of the warp suppressing layer 5 concave.

Next, another manufacturing process will be explained below. the stress relaxing layer 4 is temporarily bonded to a semiconductor chip 3 in a wafer state before dicing, and a warp suppressing layer 5 is connected to this by applying heat and pressure. Next, the semiconductor chip 3 having a laminate of the stress relaxing layer 4 and the warp suppressing layer 5 is diced individually. Next, an under-fill resin 6 is applied on a circuit board 2, and the diced semiconductor chip 3 is connected to this by applying heat and pressure to manufacture a semiconductor device 1.

As the semiconductor device 1 according to the first exemplary embodiment, although the example using the bump 9 is illustrated in Fig. 1, any connection of the electrode 8 of the semiconductor chip 3 with the circuit board 2 may be available. An ACF (Anisotropic Conductive Film) may be used for the connection, for example.

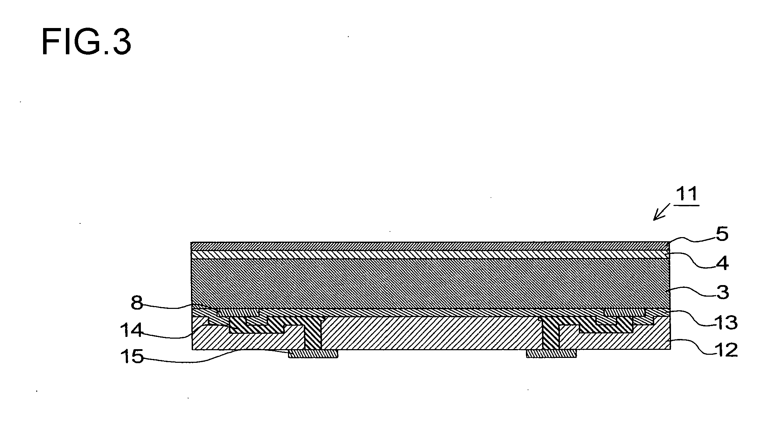

Next, a semiconductor device according to a second exemplary embodiment will be explained below. Although the first exemplary embodiment indicates the semiconductor device of the flip-chip mounting package, the second exemplary embodiment indicates a semiconductor device of the WLCSP. Fig. 3 illustrates a schematically cross-sectional view of the semiconductor device according to the second exemplary embodiment of the present invention. In a semiconductor device 11, a circuit board 12 is formed as a redistribution layer. The semiconductor chip 3 is connected with a circuit board 12 via an insulating layer 13. Each electrode 8 of the semiconductor chip 3 is electrically connected with an external connection electrode 15 of the circuit board 12, which is formed on an opposite side of the semiconductor chip 3, through a rewiring circuit 14. For the resin of the circuit board 12, the same material as the circuit board 2 in the first exemplary embodiment, photopolymer or polyimide may be used, for example. The circuit board 12 as the rewiring layer having a thickness of 0.2 mm and the coefficient of linear expansion of 10 ppm/°C to 40 ppm/°C may be connected to the semiconductor chip 3 having a thickness of 0.15 mm, for example.

The modes of the stress relaxing layer 4 and the warp suppressing layer 5 shown in Fig. 3 are the same as the first exemplary embodiment.

If the semiconductor device 11 undergoes the temperature change, although the force to curve the semiconductor device 11 is generated by the difference between the linear expansion coefficient of the semiconductor chip 3 and that of the circuit board 12, the warp suppressing layer 5 and the stress relaxing layer 4 can make the force to curve the semiconductor device 11 in the opposite direction of the former force in the same way as the first exemplary embodiment. Therefore, the warp of the semiconductor device 11 can be suppressed.

Next, a process of manufacturing the semiconductor device 11 according to the second exemplary embodiment will be explained below. In the semiconductor chip 3 in the wafer state, the circuit board 12 (rewiring layer) is formed so as to electrically connect each electrode 8 with the external connection electrode 15. Next, the stress relaxing layer 4 and the warp suppressing layer 5 are formed on the back side of the face having the electrodes 8 in the semiconductor chip 3. Next, the semiconductor chip 3 is individually diced to manufacture the semiconductor device 11.

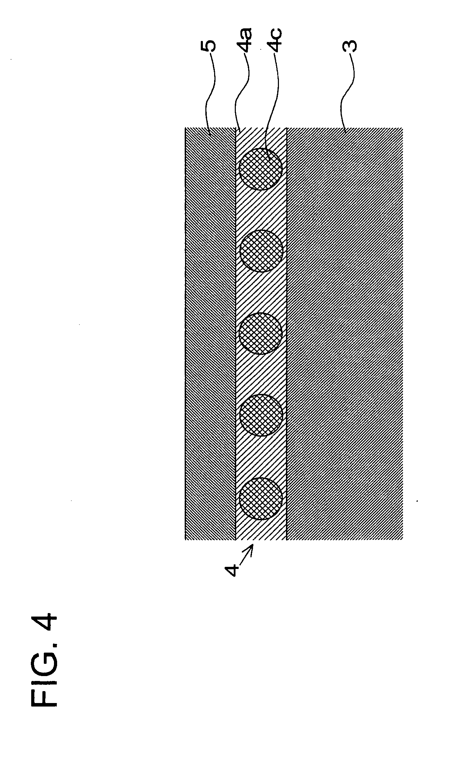

Next, a semiconductor device according to a third exemplary embodiment will be explained below. Fig. 4 illustrates a schematically enlarged view of the stress relaxing layer in the semiconductor device according to the third exemplary embodiment of the prevent invention. Although the first and second exemplary embodiments explain the mode in which the stress relaxing layer 4 has the glass cloth 4b as the spacer, in this exemplary embodiment, the stress relaxing layer 4 has granular materials 4c as the spacer which are included in the resin 4a. As the material of the granular spacer 4c, any material heat-resisting to the heat in the step of mounting the semiconductor chip 3 may be used. The granular spacer 4c may be formed by ceramics such as alumina and silica, metal such as solder, cupper and nickel, or heat-resisting resin, for example. The granular spacer 4c may have any shape and, for example, be of sphere, an ellipsoid, and rectangular parallelepiped. The surface of the granular spacer 4c may be rough.

The mode other than the stress relaxing layer 4 in the third exemplary embodiment is the same as the first and second exemplary embodiments.

According to the third exemplary embodiment, a predetermined gap between the semiconductor chip 3 and the warp suppressing layer 5 can be maintained because the thickness of the stress relaxing layer 4 is not less than at least the size of the granular spacer 4c. In case of the spherical spacer as shown in Fig. 4, for example, the granular spacers 4c are in contact with the semiconductor chip 3 or the warp suppressing layer 5 at points. Therefore, the stress relaxing layer 4 is hard to be detached from the semiconductor chip 3 and the warp suppressing layer 5 because the resin 4a of the stress relaxing layer 4 mainly contacts with the semiconductor chip 3 and the warp suppressing layer 5.

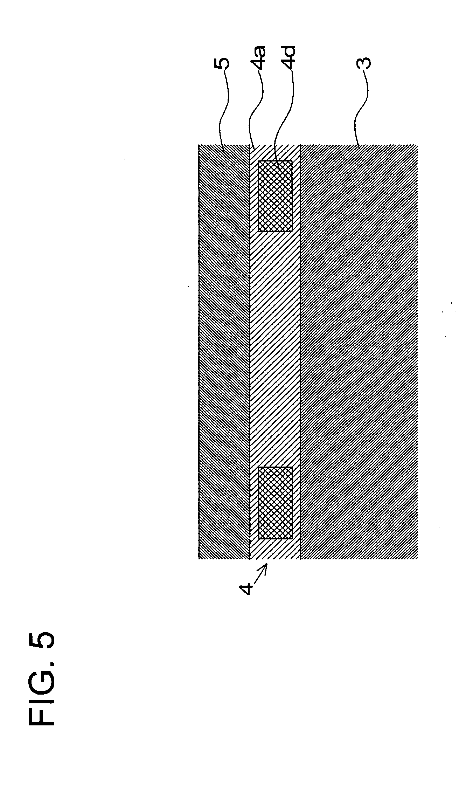

Next, a semiconductor device according to a fourth exemplary embodiment will be explained below. Fig. 5 illustrates a schematically enlarged view of the stress relaxing layer in the semiconductor device according to the fourth exemplary embodiment of the prevent invention. In this exemplary embodiment, resin is used as the spacer 4d. As the spacer 4d, for example, a pillar-shaped resin spacer sliced in advance in a semi-hardened state or entirely hardened state may be used. The resin material of the spacer 4d may be the same material as the resin 4a or different material from the resin 4a.

In a process of manufacturing the semiconductor device according to the fourth exemplary embodiment, for example, the semiconductor device of the flip-chip mounting package type may be manufactured by putting the spacers 4d on the semiconductor chip 3 mounted by the flip-chip method and laminating the resin sheet as the resin 4a and the warp suppressing layer 5 on this under application of heat and pressure.

The mode other than the stress relaxing layer 4 in the fourth exemplary embodiment is the same as the first and second exemplary embodiments.

According to the fourth exemplary embodiment, the thickness of the stress relaxing layer 4 can be maintained and, in addition, the stress relaxing layer 4 can be relatively homogenized. Therefore, the number of the parts on which the stress concentrates in the stress relaxing layer 4 can be reduced to prevent the defect such as cracks and detachment.

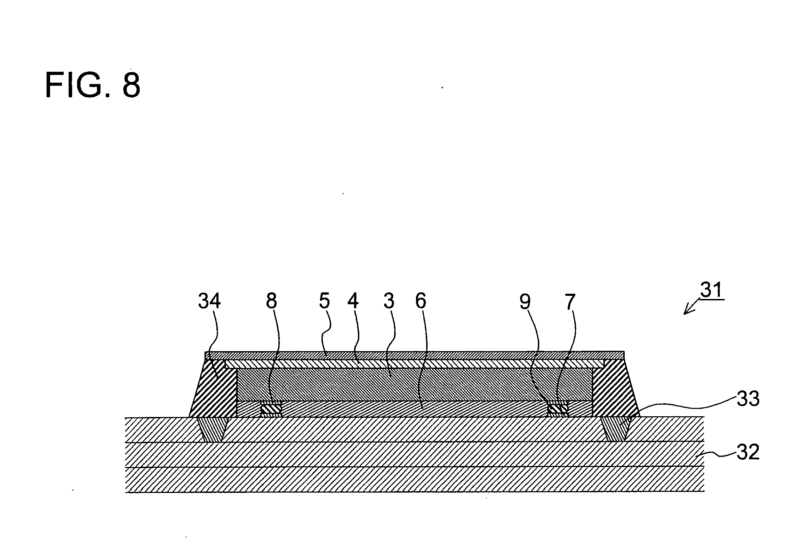

Next, a semiconductor device according to a fifth exemplary embodiment will be explained below. Fig. 8 illustrates a schematically cross-sectional view of the semiconductor device according to the fifth exemplary embodiment of the prevent invention. In this exemplary embodiment, the warp suppressing layer 5 made from a conductor is electrically connected with ground electrodes 33 of a circuit board 32 on which the semiconductor chip 3 is mounted. As shown in Fig. 8, for example, a warp suppressing layer 5 is electrically connected with the ground electrodes 33 through a conductive resin 34 having a Young's modulus lower than that of metal.

It is preferred that at least a part of the warp suppressing layer 5 protrudes from the semiconductor chip 3 (the top face or side face thereof) to electrically connect the warp suppressing layer 5 with the ground electrode 33 easily. For example, the end of the warp suppressing layer 5 which faces to the ground electrode 33 to be connected is made protruded from the semiconductor chip 3, and the conductive resin 34 of a liquid or paste type is filled up between the protruding part and the ground electrode 33 and hardened to electrically connect the warp suppressing layer 5 with the ground electrode 33.

According to this exemplary embodiment, when the semiconductor device 31 is mounted on a main board, electromagntic interference generated between the semiconductor chip 3 and a circuit outside the semiconductor device 31 can be restrained. If the soft conductive resin 34 is used, the warp suppressing layer 5 hardly have a bad influence on the warp suppressing effect.

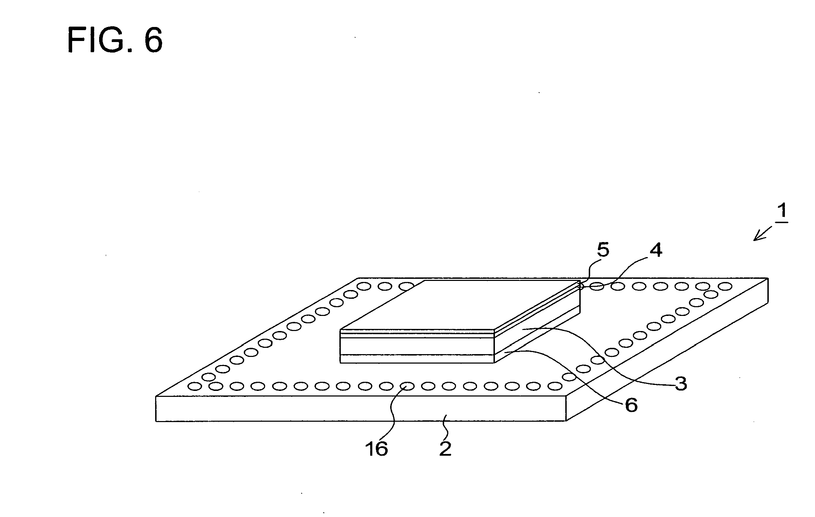

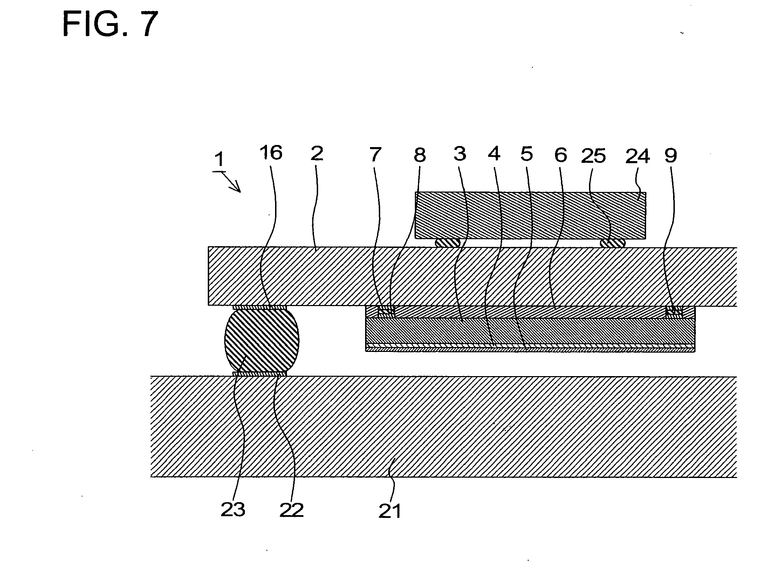

A use example of the semiconductor device according to the first to fifth exemplary embodiments of the present invention will be explained below. Fig. 6 illustrates a schematically perspective view of the semiconductor device of the present invention, and Fig. 7 illustrates a schematically and partially cross-sectional view of a state that the semiconductor device of the present invention is secondarily mounted on the main board. In Figs. 6 and 7, although the semiconductor device 1 according to the first exemplary embodiment is illustrated, it is understood that the semiconductor device according to the second [to fifth] exemplary embodiments may be used.

External connection electrodes 16 for an electrical connection with a main board 21 are formed in a peripheral area of the circuit board 2 face on which the semiconductor chip 3 is mounted. The semiconductor chip 3 faces to the main board 21 so as to locate the semiconductor chip 3 between the circuit board 2 and the main board 21, and the external connection electrode 16 of the circuit board 2 is electrically connected with an external connection electrode 22 of the main board 21 through a bump 23. On the back of the face on which the semiconductor chip 3 is mounted in the circuit board 2, an electronic element 24 may be mounted.

In the semiconductor device of the present invention, because the thickness from the under-fill resin 6 to the warp suppressing layer 5 can be made thinner than the height of the bump 23 and the warp of the semiconductor device 1 can be suppressed by the warp suppressing layer 5 and the stress relaxing layer 4, the secondary mounting in which the semiconductor chip 3 faces to the main board 21 is enabled as illustrated in Fig. 7. If the under-fill resin 6 has a thickness of 0.05 mm, the semiconductor chip 3 has a thickness of 0.1 mm, the stress relaxing layer 4 has a thickness of 0.03 mm, and the warp suppressing layer 5 has a thickness of 0.03 mm, for example, the height from the under-fill resin 6 to the warp suppressing layer 5 is equal to a total of 0.21 mm. This height is lower than the height of the bump (solder ball) 23 formed on the external connection electrode 16 having a diameter of 0.25 mm at intervals of 0.5 mm.

Next, an example of an assemble process to form the secondary mounting mode shown in Fig. 7 will be explained below. A solder ball as the bump 23 of the semiconductor device 1 is temporarily fixed on the external connection electrode 16 via solder cream, and then the solder ball is fixed on the external connection electrode 16 by the reflow. Next, a solder ball as a bump 25 of the electronic element 24 is temporarily fixed via a solder cream on an electrode (not shown) of the circuit board 2 on the back of the face on which the semiconductor chip 3 is mounted, and then fixed by the reflow. This assembly formed by this process is referred as a module.

Next, the module is mounted on the main board 21. The solder ball 23 of the module is fixed via the solder cream on the external connection electrode 22 of the main board 21 in the same manner. The temperature of the module temporarily rises to 230 °C-260 °C. If the circuit board 2 in the module is made from a resin board, the glass transition temperature of the base material of the resin board is generally 200 °C or less, and therefore the Young's modulus and the linear expansion coefficient are largely changed at about the glass transition temperature in the reflow. However, if the glass transition temperatures of the stress relaxing layer 4 and the circuit board 2 in the semiconductor device 1 are within the preferable range as described above, it is possible to suppress the warp at about the glass transition temperatures and therefore to maintain the flatness of the semiconductor device 1 in the mounting step. Thus, it is possible to keep the contact of the solder with the main board 21 in the mounting step and thereby to prevent a connection defect in an initial connection.

When the structure shown in Fig. 7 is under a condition of melting point or above of the solder in the reflow step, if the warp suppressing layer 5 is curved in the convex direction, there is probability that the connection defect arises by contacting the warp suppressing layer 5 with the main board 21 and thereby not contacting the bump 23 with the external connection electrode 22 of the main board 21. As described above, if the mounting condition is controlled so as to not make the warp suppressing layer 5 convex, that is, to make the warp suppressing layer 5 concave, it is hard to contact the warp suppressing layer 5 with the main board 21, and therefore the initial connection defect can be prevented.

The semiconductor device of the present invention may be used for an LSI package or LSI module.

Although the prevent invention is explained based on the above exemplary embodiments, the present invention is not limited to the above exemplary embodiments, and may include any modification, change and improvement to the exemplary embodiment within the scope of the present invention. Within the scope of the present invention, various combinations, displacements and selections of disclosed elements are available.

A further problem, object and exemplary embodiment of the present invention become clear from the entire disclosure of the present invention including claims.

## Claims

1. A semiconductor device comprising:
a semiconductor chip having a first electrode on one face;
a circuit board having a second electrode on a mounting face;
a warp suppressing layer to suppress a warp of at least said semiconductor chip; and
a stress relaxing layer to relax stress arising between said semiconductor chip and said warp suppressing layer; wherein
said semiconductor chip is mounted on said circuit board so as to electrically connect said first electrode with said second electrode of said circuit board and to oppose said one face to said mounting face;
said stress relaxing layer is provided on a back face of said one face in said semiconductor chip;
said warp suppressing layer is laminated on said semiconductor chip via said stress relaxing layer;
said stress relaxing layer has a spacer to maintain a predetermined gap between said semiconductor chip and said warp suppressing layer;
said stress relaxing layer has a Young's modulus lower than that of said warp suppressing layer; and
said stress relaxing layer and said warp suppressing layer have coefficients of linear expansion greater than that of said semiconductor chip.

2. A semiconductor device comprising:
a semiconductor chip having a first electrode on one face;
a circuit board having one face which faces to said semiconductor chip, a back face of said one face, a second electrode on said back face, and a conductor electrically connected with said second electrode and transversally extending from said back face to said one face;
a warp suppressing layer to suppress a warp of at least said semiconductor chip; and
a stress relaxing layer to relax stress arising between said semiconductor chip and said warp suppressing layer; wherein
said semiconductor chip is mounted on said circuit board so as to electrically connect said first electrode with said second electrode of said circuit board through said conductor and to contact said one face of said semiconductor chip with said one face of said circuit board;
said stress relaxing layer is provided on the back face of said one face in said semiconductor chip;
said warp suppressing layer is laminated on said semiconductor chip via said stress relaxing layer;
said stress relaxing layer has a spacer to maintain a predetermined gap between said semiconductor chip and said warp suppressing layer;
said stress relaxing layer has a Young's modulus lower than that of said warp suppressing layer; and
said stress relaxing layer and said warp suppressing layer have coefficients of linear expansion greater than that of said semiconductor chip.

3. The semiconductor device according to claim 1 or 2, wherein
said warp suppressing layer has a coefficient of linear expansion not less than that of said circuit board.

4. The semiconductor device according to claim 1 or 2, wherein said stress relaxing layer has a thickness of 20 µm to 60 µm.

5. The semiconductor device according to claim 1 or 2, wherein
said stress relaxing layer has a Young's modulus of 10 GPa to 40 GPa.

6. The semiconductor device according to claim 1 or 2, wherein
at least one material of said spacer is glass, ceramics, metal or resin.

7. The semiconductor device according to claim 1 or 2, wherein said spacer has a sheet shape, granular shape or pillar shape.

8. The semiconductor device according to claim 1 or 2, wherein
said stress relaxing layer has said spacer and a resin to bond said semiconductor chip with said warp suppressing layer.

9. The semiconductor device according to claim 1 or 2, wherein
a lamination of said stress relaxing layer and said warp suppressing layer has a Young's modulus not less than that of said circuit board.

10. The semiconductor device according to claim 1 or 2, wherein
said circuit board comprises a resin;
said stress relaxing layer comprises a resin; and
the difference between the glass transition temperature of the resin of said circuit board and that of the resin of said stress relaxing layer is within a range of plus/minus 20 °C.

11. The semiconductor device according to any one of claims 1-10, wherein
said warp suppressing layer is formed of a conductor;
said circuit board has a ground electrode; and
said warp suppressing layer is electrically connected with said ground electrode.

12. The semiconductor device according to claim 11, wherein
at least one part of said warp suppressing layer protrudes from said semiconductor chip; and
a conductive resin is provided between the protruding part of said warp suppressing layer and said ground electrode.
